# EUROPÄISCHE PATENTSCHRIFT

(11) **EP 3 266 115 B1**
(45) Veröffentlichungstag und Bekanntmachung des Hinweises auf die Patenterteilung: **14.10.2020**
(21) Anmeldenummer: 16719196.4
(22) Anmeldetag: 02.03.2016
(51) Int. Cl.: H04B 5/00, H03F 3/217

(54) **VERFAHREN DER INDUKTIVEN STROMÜBERTRAGUNG**
METHOD FOR THE INDUCTIVE TRANSMISSION OF CURRENT
PROCÉDÉ DE TRANSFERT D'ÉNERGIE PAR INDUCTION

(30) Priorität: 04.03.2015 DE 102015002687
(43) Veröffentlichungstag der Anmeldung: 10.01.2018
(73) Patentinhaber: WiTech GmbH, 33613 Bielefeld (DE)
(72) Erfinder: BÜKER, Maik-Julian, 33100 Paderborn (DE); EUSKIRCHEN, Jörg Rainer, 32257 Bünde (DE); SCHMIDT, Marco, 33102 Paderborn (DE)
(74) Vertreter: Bendele, Tanja
(86) Internationale Anmeldenummer: PCT/DE2016/000093
(87) Internationale Veröffentlichungsnummer: WO 2016/138887

(56) Entgegenhaltungen:
- US-A1- 2013 033 118
- KOIZUMI H: "Class D series resonant converter controlled with FPGA-based delta-sigma modulator", POWER ELECTRONICS AND DRIVE SYSTEMS, 2009. PEDS 2009. INTERNATIONAL CONFERENCE ON, IEEE, PISCATAWAY, NJ, USA, 2. November 2009 (2009-11-02), Seiten 1443-1447, XP031614497, ISBN: 978-1-4244-4166-2
- DEMIAN PIMENTEL ET AL: "Power Control for Pulse-Density Modulation Resonant Converters", INDUSTRIAL ELECTRONICS, 2006 IEEE INTERNATIONAL SYMPOSIUM ON, 9. Juli 2006 (2006-07-09), Seiten 1259-1264, XP055286413, DOI: 10.1109/ISIE.2006.295653 ISBN: 978-1-4244-0496-4

## Beschreibung

Die Erfindung betrifft ein Verfahren der induktiven Stromübertragung mittels wenigstens einer von einem Verstärker mit einer elektrischen Leistung beaufschlagten Sendespule.

Die induktive Stromübertragung für beispielsweise die Aufladung von Akkumulatoren für die Versorgung elektrischer Vorrichtungen ist vielfältig bekannt. So offenbart die EP 1 318 260 A2 die drahtlose Stromübertragung aus einem Festnetz an einen mit einem Torflügel mitbewegten Akkumulator. Des Weiteren offenbart die US2013/0033118 A1 ein System zur induktiven Leistungsübertragung unter Verwendung eines Class D/DE Verstärkers im Zero-Voltage-Switching und/oder im Zero-Current-Switching Modus. 1

Der Artikel "Power Control for Pulse-Density Modulation Resonant Converters", veröffentlicht auf dem IEEE International Symposium on Industrial Electronics (ISIE) im Juli 2006 offenbart die Verwendung einer Pulsdichtenmodulation zur Leistungssteuerung eines Leistungswandlers im Zero-Voltage-Switching oder im Zero-Current-Switching Modus. 1

Der Artikel "Class D series resonant converter controlled with FPGA-based delta-sigma modulator", veröffentlicht auf der IEEE International Conference on Power Electronics and Drive Systems im November 2009 offenbart die Verwendung einer Pulsdichtenmodulation zur Leistungssteuerung eines Class D Verstärkers im Zero-Current-Switching Modus.

Einen weiteren Verwendungszweck offenbart DE 10 2010 047 579 A1. Dort wird ein flächenhaft sich erstreckendes Möbelbauteil offenbart, beispielsweise eine Tisch- oder Arbeitsplatte, in dem eine Vielzahl von Sendespulen für eine induktive Stromübertragung für eine elektrisch betriebene Vorrichtung wie insbesondere einen Laptop, ein Smartphone, ein Tablet oder dergleichen integriert ist.

Ziel ist dort, dass ein beliebig auf dem Möbelbauteil abgesetzter elektrischer Verbraucher eine Stromversorgung erfährt.

Derartige Verbraucher lassen sich in verschiedene Leistungsklassen der Stromaufnahme einteilen. Um eine optimale Stromversorgung solch unterschiedlicher Verbraucher sicherzustellen, bedarf es der Übertragung auch unterschiedlicher Leistungen. Ein die wenigstens eine Sendespule mit einer elektrischen Leistung beaufschlagender Verstärker muss deshalb sehr effizient und störungsarm ausgelegt sein. Dies gilt insbesondere auch bei einem hohen Frequenzbereich ab etwa 500 kHz für die drahtlose Energieübertragung.

Gelöst wird diese technische Problematik durch ein Verfahren der induktiven Stromübertragung mittels eines wenigstens einer von einem Verstärker mit einer elektrischen Leistung beaufschlagten Sendespule gemäß des Merkmals des Anspruchs 1 durch die Maßnahme, dass der Verstärker in einem Zero Voltage Switching (ZVC) und Zero Current Switching (ZCV) Modus betrieben wird.

Durch das Schalten elektronischer Schalter wie Transistoren des Verstärkers im Nulldurchgang der Spannung und im Nulldurchgang des Stroms werden die Verlustleistungen der elektronischen Schalter minimiert und Störungen weitestgehend vermieden, womit ein sicherer, stabiler Betrieb auch bei hohen Frequenzen gewährleistet wird.

Allerdings sind nur wenige Schaltmoden geeignet, beide Bedingungen gleichzeitig zu erfüllen. Möglich ist dies bei einem Verstärker der Klasse D, der von einer Ablaufsteuerung nachgeregelt wird und so gleichsam einen Verstärker der Klasse DE darstellt.
Eine solche Ablaufsteuerung kann als eigenständige, frei programmierbare logische Einheit ausgebildet sein oder durch eine Asic, eine anwendungsspezifische integrierte Schaltung.

In konstruktiver Ausgestaltung des Verfahrens nach der Erfindung ist vorgesehen, dass der Verstärker eine Halbbrücke mit zwei elektronischen Schaltern, einen Reihenschwingkreis und zwei den elektronischen Schaltern jeweils zugeordnete Kapazitäten aufweist, dass die Ablaufsteuerung zwei um einen Halbtakt versetzte Rechtecksignale für die Ansteuerung der elektronischen Schalter generiert, deren Pulsweite derart bemessen ist, dass eine sich entladende Kapazität genau dann entladen ist, wenn das nächste Rechtecksignal ansteht.

Die Kapazitäten können durch geeignete, zu den Schaltern parallel geschaltete Kondensatoren ausgebildet werden, durch Schalterkapazitäten selbst oder entsprechende Kombinationen.

Die Pulsweitenmodulation dient hier nicht, wie bei Verstärkern der Klasse D üblich, der Leistungssteuerung, sondern der Abstimmung des Verstärkermodus der Klasse DE, dem Zero Voltage Switching und dem Zero Current Switching. Dabei ist weiter vorgesehen, dass die Ablaufsteuerung als Rechtecksignale Pulse fester Frequenz generiert, die zwei Werte annehmen können. Allerdings ist auch vorgesehen, dass die Ablaufsteuerung als Rechtecksignale Pulse vorgebbarer Pulsweiten generiert. In Kombination dieser letztgenannten Merkmale ist damit der Abstand zwischen zwei steigenden Flanken aufeinanderfolgender Pulse immer gleich. Es ändert sich lediglich die Pulsweite.

Diese Pulsweitenmodulation dient nicht der Regulierung der Verstärkerleistung, sondern dient dem Betrieb desselben in den genannten Moden. Für die Leistungsregelung ist vorgesehen, dass die Rechtecksignale in gleichmäßige Intervalle aufgeteilt sind und dass für eine Leistungsregelung des Verstärkers von der Ablaufsteuerung eine vorgebbarere Anzahl von Pulsen in dem Intervall generiert wird, einem Thinning Out.

Werden keine Pulse übertragen, verbleibt das Signal auf Null und es wird keine Energie übertragen.

Für ein sauberes Schalten der elektronischen Schalter kann weiter vorgesehen sein, dass für ein Ausschwingen der Halbbrücke diese einseitig kurzgeschlossen wird, was eine Zwangsabschaltung dem Grunde nach darstellt.

Um einen optimalen Betrieb des Senders für die induktive Stromübertragung sicherzustellen ist ferner eine Regelschleife zwischen der pulserzeugenden Ablaufsteuerung und der Halbbrücke vorgesehen. Hierdurch ist es möglich, dass durch ausgewertete Signale der Halbbrücke die Pulsweiten derart eingestellt werden, dass die Halbbrücke auch optimal betrieben wird. Zweckmäßigerweise ist hierfür ein Mikrocontroller vorgesehen, von dem die Ablaufsteuerung über einen Datenbus Informationen erhält. Diese Informationen können darüber hinaus Angaben für die Leistungsregelung des Verstärkers enthalten, so dass eine optimale drahtlose Energieübertragung auch für Geräte unterschiedlicher Leistungsklassen möglich ist.

Als zweckmäßig hat es sich insgesamt erwiesen, wenn die Ablaufsteuerung ein Complex Programmable Logic Device (CPLD) ist, eine programmierbare logische Einheit. Im Gegensatz zu einem Field Programmable Gate Array (FPGA) verliert ein CPLD seine Programmierung bei einem Verlust der Versorgungsspannung nicht, da diese auf einer EEPROM-Technologie basiert. Als Alternative bietet sich eine integrierte anwendungsspezifische Schaltung für die Ablaufsteuerung an.

Das Wesen der Erfindung wird anhand der Zeichnung näher erläutert, in der lediglich schematische und beispielhafte Darstellungen wiedergegeben sind. In der Zeichnung zeigt:
- Fig. 1:: die Schaltung eines Wechselrichters als Verstärker,
- Fig. 2:: eine optimale Pulsweitenregelung,
- Fig. 3:: eine zu große Pulsweitenregelung,
- Fig. 4:: eine zu kleine Pulsweitenregelung,
- Fig. 5:: das Thinning Out und
- Fig. 6:: ein vereinfachtes Blockschaltbild für die drahtlose Energieübertragung nach der Erfindung.

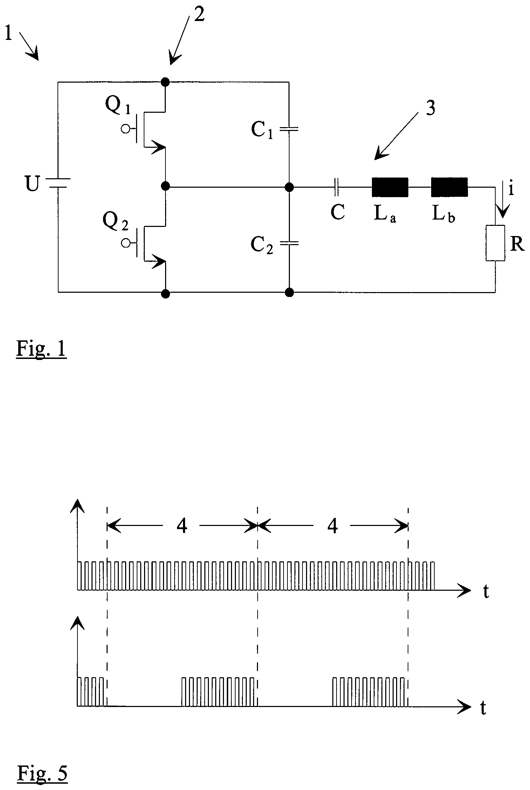

Figur 1 zeigt die Ausbildung eines Verstärkers 1 für die Durchführung des Verfahrens nach der Erfindung als Wechselrichter mit einer Halbbrücke 2 mit zwei elektronischen Schaltern Q₁, Q₂, beispielsweise Transistoren.

Im Lastkreis der beiden elektronischen Schalter Q₁, Q₂ ist ein Reihenschwingkreis 3 mit der Kapazität C und der Induktivität Lₐ geschaltet. Eine mit dem Reihenschwingkreis 3 in Reihe geschaltete weitere Induktivität L_{b} bildet mit der Induktivität Lₐ die Sendespule aus. Über einen ohmschen Widerstand R wird der Laststromkreis geschlossen.

Parallel zu den elektronischen Schaltern Q₁, Q₂ sind zwei Kapazitäten C₁, C₂ geschaltet.

Je nach Schalterstellung der elektronischen Schalter Q₁, Q₂ wird eine der beiden Kapazitäten C₁, C₂ mit der Versorgungsspannung U geladen bzw. über den Laststromkreis entladen.

Für den Betrieb des Verstärkers 1 werden an den elektronischen Schaltern Q₁, Q₂ Rechtecksignale gleicher Frequenz benötigt, die um einen Halbtakt versetzt sind. Infolgedessen ergibt sich ein Wechselstrom an den Induktivitäten Lₐ und L_{b}.

Für eine möglichst hohe Effizienz der induktiven Energieübertragung müssen die elektronischen Schalter Q₁, Q₂ mit optimal aufeinander abgestimmten Rechtecksignalen angesteuert werden. Die Pulsweite muss gerade so groß sein, dass sich die Kapazitäten C₁, C₂ innerhalb der von der Pulsweite abhängigen Entladezeit t_{D} durch die induktive Wirkung des Laststromkreises entladen können. Eine der Kapazitäten C₁, C₂ soll genau dann entladen sein, wenn ein Puls den anderen elektronischen Schalter Q₂, Q₁ ansteuert und damit beginnt, die zweite Kapazität C₂, C₁ aufzuladen. Dies ist der Fall, wenn genau dann ein Puls an einem elektronischen Schalter Q₁, Q₂ ankommt, wenn die Spannung bzw. der Strom Null ist, womit der Verstärker in einem Zero Voltage Switching und Zero Current Switching Modus betrieben wird.

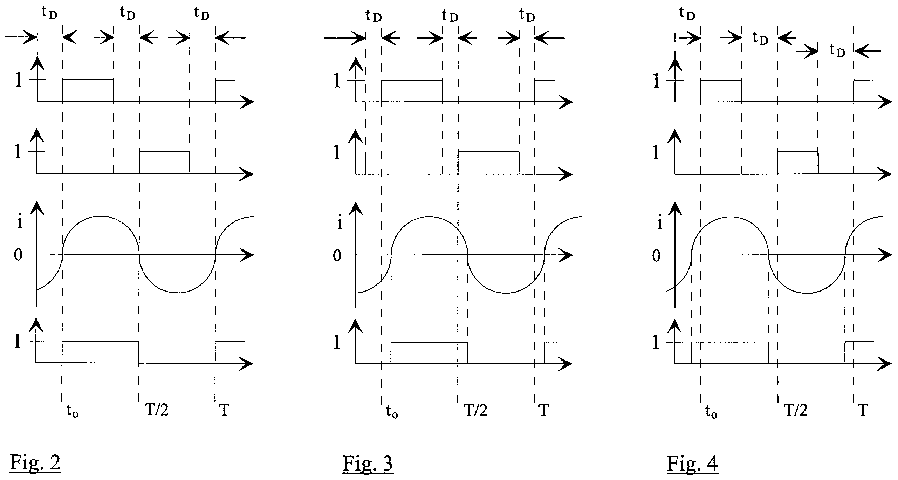

Figur 2 zeigt in den zwei oberen Koordinatensystemen die um einen Halbtakt T/2 versetzten Rechtecksignale, hier auf eins normiert. Die Pulsweite der beiden Rechtecksignale ist optimal, so dass der Strom i von den elektronischen Schaltern Q₁ bzw. Q₂ im Nulldurchgang geschaltet wird. Das in dem untersten Koordinatensystem normiert wiedergegebene Nulldurchgangssignal beginnt mit dem Flankenanstieg des ersten Rechtecksignals und endet mit den Anstieg des zweiten Rechtecksignals. Der Abstand zwischen der absteigenden Flanke des ersten Rechtecksignals bis zum Anstieg des zweiten Rechtecksignals bzw. zwischen der absteigenden Flanke des zweiten Rechtecksignals bis zur ansteigenden Flanke des dritten Rechtecksignals entspricht der Entladezeit t_{D}.

In Figur 3 ist die Pulsweite zu groß dargestellt. Entsprechend erfolgt der Nulldurchgang des Stroms i zu spät bzw. in der Figur 4 mit zu kleiner Pulsweite zu früh. Da in diesen beiden Fällen die Einschaltzeitpunkte der Rechtecksignale nicht mehr mit dem Nulldurchgang des Stroms i übereinstimmen, verringert sich der Wirkungsgrad der Schaltung deutlich.

Für die Modulation der optimalen Pulsweite ist eine Ablaufsteuerung vorgesehen, beispielsweise ein Complex Programmable Logic Device, CPLD oder eine Asic. Diese Pulsweitenmodulation mit Pulsen fester Frequenz, jedoch vorgebbarer Pulsweiten dient nicht der Regelung der von dem Verstärker 1 abgegebenen Leistung, sondern ausschließlich dem optimalen Betrieb, dem exakten Schalten der elektronischen Schalter Q₁, Q₂.

Allerdings erfolgt auch die Regelung der induktiv übertragenen Leistung durch die Ablaufsteuerung. Diese generiert in einem Intervall 4 normalerweise eine vorgebbare Anzahl von Pulsen, in Figur 5 beispielsweise 20 Impulse, oberes Koordinatensystem. Für eine Verringerung der induktiv zu übertragenden Leistung werden jedoch nicht diese 20 Pulse generiert, sondern weniger, in Figur 5 beispielsweise nur 10, unteres Koordinatensystem.

Dabei sind die beiden elektronischen Schalter Q₁, Q₂ derart zu beschalten, dass in der Zeit, in der keine Pulse übertragen werden, keine induktive Energieübertragung stattfindet.

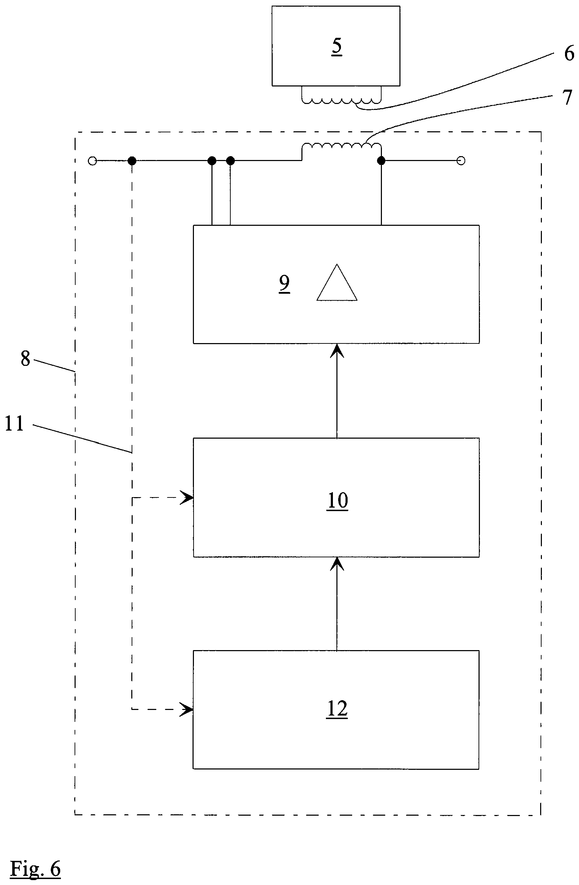

Figur 6 zeigt, vereinfacht, dass Gesamtkonzept des erfindungsgemäßen Verfahrens nochmals auf. Ein Verbraucher 5 ist über eine Empfängerspule 6 für eine induktive Stromübertragung mit einer Sendespule 7 eines Senders 8 gekoppelt. Gespeist wird die Sendespule 7 von einem Verstärker 9 der eingangs erläuterten Art. Die das Schaltverhalten des Verstärkers 9 vorgebende Ablaufsteuerung 10 erhält die notwendigen Informationen für die Anpassung der Pulsweite durch eine strichpunktiert angedeutete Regelschleife 11 beispielsweise als Phasensignal unmittelbar aus der Schaltung oder über einem Mikrocontroller 12. Dieser kann darüber hinaus weitere Informationen, beispielweise hinsichtlich der Leistungsklasse des Verbrauchers 5, für eine Leistungsanpassung des Verstärkers 9 an die Ablaufsteuerung 10 weitergeben. Ein optimaler Betrieb des Verstärkers 9 sowie eine optimale Leistungsanpassung des Verstärkers 9 an den Verbraucher 5 sind damit gewährleistet.

## Patentansprüche

1. Verfahren der induktiven Stromübertragung mittels wenigstens einer von einem Verstärker mit einer elektrischen Leistung beaufschlagten Sendespule, wobei der Verstärker in einem Zero Voltage Switching (ZVC) und Zero Current Switching (ZCV) Modus betrieben wird, wobei der Verstärker einer der Klasse D ist, der von einer Ablaufsteuerung nachgeregelt wird, wobei die Ablaufsteuerung als Rechtecksignale Pulse vorgebbarer Pulsweiten generiert, und wobei eine vorgebbare Anzahl von Pulsen in gleichmäßige Intervalle aufgeteilt ist und für eine Leistungsregelung des Verstärkers von der Ablaufsteuerung in dem Intervall eine geringere Anzahl von Pulsen als die vorgegebene Anzahl von Pulsen generiert wird, wobei eine Pulsweitenmodulation bei Verstärkern der Klasse D nicht einer Leistungssteuerung dient, wobei die Pulsweitenmodulation ausschließlich einer Abstimmung eines Verstärkermodus der Klasse DE, dem Zero Voltage Switching und dem Zero Current Switching dient, wobei für die Leistungsregelung vorgesehen ist, dass die Rechtecksignale in gleichmäßige Intervalle aufgeteilt sind und, dass für eine Leistungsregelung des Verstärkers von der Ablaufsteuerung eine vorgebare Anzahl von Pulsen in dem Intervall generiert wird, was einem Thinning Out entspricht, wobei der Verstärker eine Halbbrücke mit zwei elektronischen Schaltern, einen Reihenschwingkreis und zwei den elektronischen Schaltern jeweils zugeordnete Kapazitäten aufweist und dass die Ablaufsteuerung zwei um einen Halbtakt versetzte Rechtecksignale für die Ansteuerung der elektronischen Schalter generiert, deren Pulsweite derart bemessen ist, dass eine sich entladende Kapazität genau dann entladen ist, wenn das nächste Rechtecksignal ansteht, wobei für ein Ausschwingen der Halbbrücke diese einseitig kurzgeschlossen wird.

2. Verfahren nach Anspruch 1, **dadurch gekennzeichnet, dass** die Ablaufsteuerung als Rechtecksignale Pulse fester Frequenz generiert.

3. Verfahren nach einem oder mehreren der Ansprüche 1 bis 2, **gekennzeichnet durch** eine Regelschleife zwischen der pulserzeugenden Ablaufsteuerung und der Halbbrücke vorgesehen ist.

4. Verfahren nach Anspruch 3, **dadurch gekennzeichnet, dass** die Ablaufsteuerung über einen Datenbus von einem Mikrocontroller Informationen für eine Regelung der Leistung erhält.

5. Verfahren nach einem oder mehreren der vorangehenden Ansprüche, **dadurch gekennzeichnet, dass** die Ablaufsteuerung ein Complex Programmable Logic Device (CPLD) oder eine Asic ist.

## Claims

1. Method of inductive current transmission by means of at least one transmission coil subjected with an electrical power by an amplifier, the amplifier being operated in a zero-voltage switching (ZVC) and zero current switching (ZCV) mode, the amplifier being a class D amplifier that is readjusted by a sequence control, the sequence control generating pulses of presetable pulse widths as square-wave signals, and a presetable number of pulses being divided into equally dimensioned intervals, and the sequence control generating a lower number of pulses than the preseted number of pulses in the interval for power control of the amplifier, a pulse width modulation in case of class D amplifiers not being intended for power control, the pulse width modulation exclusively being intended for tuning an amplifier mode of class DE, for zero voltage switching and for zero current switching, wherein it is provided for power control that the square-wave signals are divided into equally dimensioned intervals and that the sequence control generates a presetable number of pulses in the interval, corresponding to a thinning out, for power control of the amplifier, the amplifier having a half bridge having two electronic switches, a series resonant circuit and two capacities assigned to the electronic switches, and that the sequence control generates two square-wave signals being phase-shifted by a half period for controlling the electronic switches, the pulse width of which is dimensioned such that a discharging capacity is discharged exactly when the following square-wave signal is present, the half bridge being short-circuited one-sidedly for a decay of the half bridge.

2. Method according to claim 1, **characterised in that** the sequence control generates pulses of fixed frequency as square-wave signals.

3. Method according to one or more of the preceding claims 1 to 2, **characterised in** a control loop being provided between the pulse-generating sequence control and the half bridge.

4. Method according to claim 3, **characterised in that** the sequence control receives information for control of power via a data bus from a microcontroller.

5. Method according to one or more of the preceding claims, **characterised in that** the sequence control is a complex programmable logic device (CPLD) or an ASIC.

## Revendications

1. Procédé de la transmission de courant inductive au moyen d'au moins une bobine émettrice soumise avec une puissance électrique par un amplificateur, l'amplificateur étant exploité dans un mode de commutation au zéro de tension (ZVC) et de commutation au zéro de current (ZCV), l'amplificateur étant un amplificateur classe D qui est réajusté par une commande séquentielle, la commande séquentielle générant des impulsions des largeurs d'impulsion prédéfinies en tant que des signaux d'onde carré, et un nombre prédéfini des impulsions étant divisé en intervalles également dimensionnés, et la commande séquentielle générant un nombre d'impulsions inférieur que le nombre d'impulsions prédéfini dans l'intervalle pour une contrôle de puissance de l'amplificateur, une modulation de largeur d'impulsion en cas des amplificateurs classe D non étant pas destiné pour une contrôle de puissance, la modulation de largeur d'impulsion exclusivement étant destinée pour un réglage d'un mode d'amplificateur de la classe DE, de la commutation au zéro de tension et de la commutation au zéro de current, selon lequel il est prévu pour la commande séquentielle que les signaux d'onde carré sont divisés en intervalles également dimensionnés et que la commande séquentielle génère un nombre prédéfini des impulsions dans l'intervalle, correspondant à un éclaircissage, pour une contrôle de puissance de l'amplificateur, l'amplificateur ayant un demi-pont ayant deux interrupteurs électroniques, un circuit résonnant en série et deux capacités assignés aux interrupteurs électroniques, et que la commande séquentielle génère deux signaux d'onde carré étant déphasés d'une demi-période pour contrôler les interrupteurs électroniques, la largeur d'impulsion desquels est dimensionnée de la sorte qu'une capacité déchargeant est déchargée exactement quant le signal d'onde carré suivant est présent, le demi-pont étant court-circuité unilatéralement pour un oscillation de fin du demi-pont.

2. Procédé selon la revendication 1, **caractérisé en ce que** la commande séquentielle génère des impulsions de fréquence fixe en tant que des signaux d'onde carré.

3. Procédé selon l'une ou plusieurs des revendications précédentes 1 à 2, caractérisé en une boucle de régulation étant prévue entre la commande séquentielle à générer des impulsions et le demi-pont.

4. Procédé selon la revendication 3, **caractérisé en ce que** la commande séquentielle reçoive des informations pour un contrôle de puissance via un bus de données par un microcontrôleur.

5. Procédé selon l'une ou plusieurs des revendications précédentes, **caractérisé en ce que** la commande séquentielle est un circuit logique programmable complexe (CPLD) ou un ASIC.
